# EUROPÄISCHE PATENTSCHRIFT

(11) **EP 0 451 533 B1**
(45) Veröffentlichungstag und Bekanntmachung des Hinweises auf die Patenterteilung: **11.01.1995**
(21) Anmeldenummer: 91103915.4
(22) Anmeldetag: 13.03.1991
(51) Int. Cl.: H01L 41/22

(54) **Piezoelektrische keramische Wandlerscheibe und Verfahren zu ihrer Herstellung**
Piezoelectric ceramic transducer disc and process for making the same
Transducteur piézo-électrique céramique en forme de disque et procédé de sa fabrication

(30) Priorität: 16.03.1990 DE 4008470
(43) Veröffentlichungstag der Anmeldung: 16.10.1991
(73) Patentinhaber: Hoechst CeramTec Aktiengesellschaft, 95100 Selb (DE)
(72) Erfinder: Ullherr, Fritz, W-8560 Lauf a.d. Pegnitz (DE); Grosshäuser, Raimund, W-8522 Herzogenaurach (DE); Handschuh, Kurt, W-8501 Eckental (DE)
(74) Vertreter: Hoffmann, Peter, Dipl.-Chem.

(56) Entgegenhaltungen:
- EP-A- 0 196 839
- EP-A- 0 299 415
- US-A- 4 475 014
- PATENT ABSTRACTS OF JAPAN vol. 9, no. 165 (E-327) 10 Juli 1985,& JP-A-60 041272
- O. Neufang, Lexikon der Elektronik, 1983, Friedr. Vieweg und Sohn Braunschweig/Wiesbaden, Seite 272

## Beschreibung

Die Erfindung bezieht sich auf eine beidseitig metallisierte piezoelektrische, keramische Wandlerscheibe, bei der auf der Vorderseite zwei einander nicht berührende dünne metallische Elektrodenflächen angeordnet sind, von denen die eine mit der metallisierten Rückseite der Scheibe elektrisch verbunden ist.

Piezokeramische Wandlerscheiben werden als Tongeber in Telefonanlagen, als Körperschallmikrophon (Körperschallsensor) und insbesondere als Glasbruchsensor in der Technik eingesetzt.

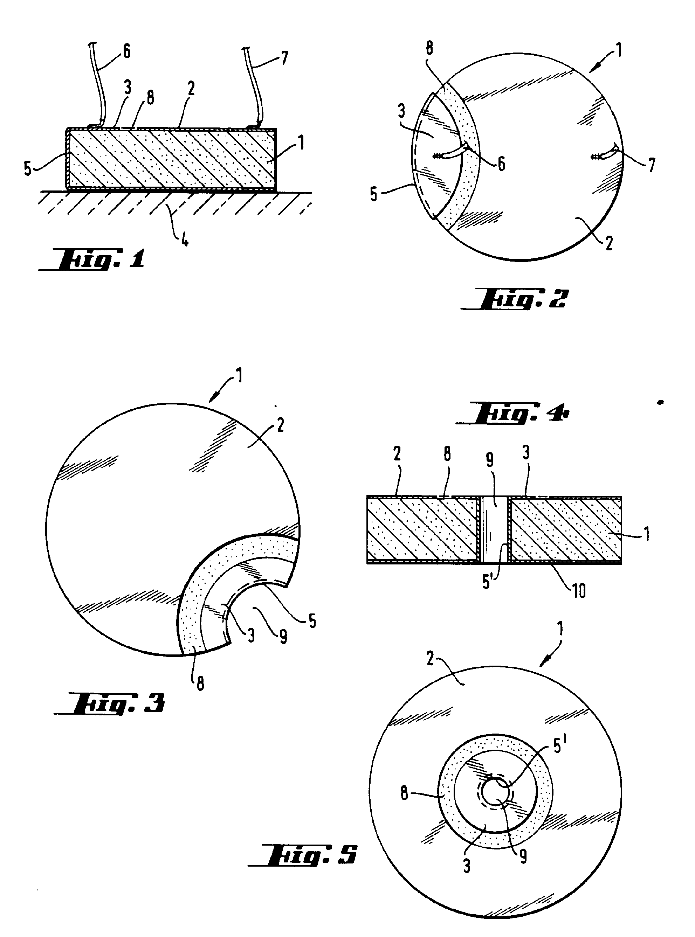

Bei Glasbruchsensoren wandelt die piezoelektrische Scheibe, bedingt durch den Piezoeffekt, die Glasschwingung in ein elektrisches Signal um, das an den Elektroden abgenommen werden kann. Nach dem Aufkleben des Sensors auf die Scheibe ist jedoch nur noch eine Seite zugänglich. Daher wird nach dem Stand der Technik der Elektrodenbelag der Rückseite um den Rand der Scheibe auf die Deckfläche der Scheibe herumgezogen. Danach kann die Scheibe durch Anlöten von Drähten kontaktiert werden. Diese bekannte Anordnung ist in den Figuren 1 und 2 dargestellt. Figur 1 stellt die Scheibe im Schnitt, Figur 2 die Vorderseite der Scheibe dar. Eine Scheibe (1) aus piezoelektrischer Keramik ist mit metallischen Elektrodenbelägen (2) und (3), z.B. aus Einbrennsilber, versehen und auf die Glasscheibe (4) aufgeklebt (Kleber nicht dargestellt). Der Elektrodenbelag (3) wird durch die am Rand verlaufende Verbindung (5) zur Deckfläche (= Rückseite) gezogen. Anschließend können die Elektrodenbeläge (2) und (3) mit Drähten (6) und (7) versehen werden. In Figur 2 ist zu sehen, daß die beiden Elektrodenbeläge (2) und (3) durch eine metallisierungsfreie Zone (8) getrennt sind.

Ein Verfahren zur Herstellung dieser bekannten piezokeramischen Wandlerscheiben beinhaltet hohe Herstellungskosten, da der herumgezogene Belag üblicherweise nur manuell durch Aufstreichen einer Metallisierungspaste ausgeführt werden kann. Eine Mechanisierung ist nur mit hohem maschinentechnischem Aufwand möglich. Nachteilig ist ferner eine hohe Ausfallquote sowohl bei der Herstellung der Teile als auch im Betrieb, da an den Kanten der Scheibe durch mechanische Beschädigungen leicht eine Unterbrechung der elektrischen Leitung erfolgen kann.

Der Erfindung liegt die Aufgabe zugrunde, eine piezoelektrische, keramische Wandlerscheibe zu schaffen, die die Möglichkeit bietet, über eine Stirnfläche auch die Elektrode der Rückseite elektrisch zu kontaktieren, aber die genannten Nachteile, insbesondere Unzuverlässigkeit im Betrieb durch mechanische Beschädigung der um den Rand geführten Leiterbahn, nicht aufweist.

Aus EP-A-0 262 248 ist bekannt, daß man durch Sprühen oder Siebdruck auf einen mit Löchern versehenen piezoelektrischen Polymerfilm eine leitende Verbindung zu einer auf der Rückseite des Films angeordneten Elektrode erzeugen kann. Dabei werden die Löcher ganz oder teilweise durch leitfähiges Material gefüllt. Es findet sich jedoch kein Hinweis, daß dieses Verfahren auch zur Herstellung von Kontakten an piezoelektrischen Wandlerscheiben aus Oxidkeramik eingesetzt werden kann.

Aus EP-A-0 299 415 sind piezoelektrische Vibratoren bekannt bei denen eine piezoelektrische Keramik zwischen zwei Elektroden angeordnet ist, deren eine in zwei gleichgroße Hälften geteilt ist. Es ist eine Scheibe dargestellt, die eine kreisrunde Geometrie aufweist und im Zentrum des Kreises eine Ausnehmung. Die elektrische Verbindung einer Elektrode der Vorderseite mit der Elektrode der Rückseite wird allerdings über eine elektrische Schaltung bewirkt und nicht durch die zentrale Ausnehmung.

Es wurde nun eine piezokeramische Wandlerscheibe gefunden, bei der auf der Vorderseite zwei einander nicht berührende dünne metallische Elektrodenflächen angeordnet sind, von denen die eine mit der metallisierten Rückseite der Scheibe in elektrisch leitender Verbindung steht und die dadurch gekennzeichnet ist, daß die elektrische Verbindung der beiden Seiten durch eine in Dickenrichtung der Scheibe verlaufende Ausnehmung mit metallisierter Mantelfläche gebildet wird.

Nach einer besonderen Ausführungsform kann die elektrische Verbindung durch ein in Dickenrichtung der Scheibe verlaufende rinnenförmige Ausnehmung am Umfang der Scheibe gebildet werden. Durch diese Formgebung ist die elektrische Verbindung gut vor mechanischer Einwirkung geschützt. Vorzugsweise besitzt die Scheibe - mit Ausnahme der rinnenförmigen Ausnehmung - einen kreisförmigen Umfang, so daß mindestens 90 % des Umfangs kreisförmig sind.

Nach einer anderen Ausführungsform sind beide Elektrodenflächen durch ein Loch mit metallisierter Mantelfläche miteinander elektrisch leitend verbunden. Für ein leichteres Einpassen der Scheibe in Geräte ist es von Vorteil, wenn die Scheibe Symmetrieelemente aufweist und das Loch im Zentrum der Scheibe angeordnet ist. Insbesondere ist die Scheibe kreisförmig. Besonders bevorzugt ist es, wenn auch die mit der Rückseite in Verbindung stehende Elektrodenfläche kreisförmig ist und zentrisch um das Loch angeordnet ist. Die nicht mit der Rückseite in Verbindung stehende Elektrodenfläche ist vorzugsweise kreisringförmig ausgebildet und ebenfalls konzentrisch zum Loch angeordnet.

Zur Herstellung einer erfindungsgemäßen piezoelektrischen Wandlerscheibe, die aus einer Keramikscheibe mit flächig aufgebrachten Metallelektroden besteht, werden durch Metallisierung auf der Vorderseite der Piezokeramikscheibe zwei Elektroden und auf der Rückseite eine Elektrode aufgebracht, und eine Elektrode der Vorderseite mit der Elektrode der Rückseite elektrisch verbunden. Hierzu verwendet man eine Scheibe mit einer Ausnehmung und metallisiert zur Bildung der elektrischen Verbindung der beiden Seiten die Manteloberfläche der Ausnehmung ebenfalls.

Dabei muß selbstverständlich die Ausnehmung so angeordnet sein, daß sie jeweils im Bereich eines metallisierten Teils der Scheibe liegt.Im Prinzip kann jedoch die Bohrung an jeder Stelle der Keramikscheibe angebracht werden. Zur Herstellung der Ausnehmung kann man die Scheibe durchbohren; dann muß später die Mantelfläche des Bohrkanals ebenfalls metallisiert werden. Man kann jedoch auch eine Scheibe mit einer rinnenförmigen Ausnehmung am Rande einsetzen und die Rinne metallisieren. Vorteilhafterweise erfolgt die Metallisierung von Scheibe und Ausnehmung gleichzeitig. Figur 3 zeigt die Vorderseite einer Scheibe mit einer rinnenförmigen Ausnehmung (9).

Figur 4 zeigt eine erfindungsgemäße Scheibe mit einem zentrisch angebrachten Loch im Schnitt. Figur 5 zeigt die Vorderseite der Scheibe von Figur 4.

Die Keramikscheibe (1) weist eine Bohrung (9) in Dickenrichtung auf. Auf der unteren Stirnfläche wird die Metallisierung (10) aufgebracht, z.B. eine Einbrennsilberpaste mittels Siebdruckverfahren. Durch entsprechende Vorrichtungen beim Siebdrucken, die z.B. leichten Unterdruck erzeugen, wird die Metallisierungspaste in die Bohrung (9) hineingezogen und dadurch die Mantelfläche der Bohrung (9) mit einem leitfähigen Belag (5′) versehen. Diese Pasten werden üblicherweise zwischen 500°C und 900°C eingebrannt.

Die Vorderseite der Scheibe (1) wird ebenfalls durch Aufbringen eines Metallisierungsbelages metallisiert. Durch entsprechende Ausbildung der Siebdruckschablonen ergeben sich die in Figur 5 dargestellten vorderen Elektrodenflächen. Hierbei stellt der Metallisierungsbelag (2) die vordere Elektrode der Scheibe dar. Die ringförmige Zone (8) ist eine metallisierungsfreie Isolationsstrecke zwischen der Vorderelektrode (2) und der Elektrode (3), die durch die Bohrung (9) über die Metallisierung (5′) mit der Rückelektrode (10) leitend verbunden ist. Die Elektrodenfläche 2 muß den Rand der Scheibe nicht berühren.

Bei der beschriebenen Ausführungsform wurden Silberbeläge per Siebdruck aufgebracht. Natürlich sind auch andere bekannte Metallisierungsmethoden und für diesen Zweck eingesetzte Metallbeschichtungen anwendbar. Beispielsweise eignet sich das erfindungsgemäße Verfahren hervorragend bei Anwendung von stromlosen chemischen Metallisierungsverfahren, wie Aufbringen von Nickel- oder Kupferbelägen. Da sich hierbei die Metallbeläge an allen Keramikstellen abscheiden, ist lediglich ein Abdecklack auf die Isolationszone (8) aufzubringen. Damit wird die Elektrodenstruktur durch einen einzigen Arbeitsgang erhalten.

Auch alle anderen üblichen Metallisierungsverfahren wie Aufdampfen und Aufsputtern von Metallisierungsbelägen sind anwendbar.

Der herumgeführte Elektrodenbelag (5′) ist bei der geschilderten Anordnung vor äußeren mechanischen Beschädigungen geschützt, da er sich vom Umfang der Scheibe zurückgesetzt im Inneren der Schiebe befindet.

Die Anordnung des Durchführungsloches radialsymmetrisch in der Mitte bietet für den Weiterverarbeiter große Vorteile. Da sich der Anschlußkontakt immer an der gleichen Stelle im Zentrum der Scheibe befindet, muß in Bestuckungs-, Montage- und Lötautomaten die Scheibe nicht mehr ausgerichtet werden. Dies gestattet eine vollautomatische Weiterverarbeitung z.B. mittels Surface mounted technology.

Die erfindungsgemäßen piezoelektrischen Wandlerscheiben eignen sich vorzüglich zum Einsatz als Körperschallsensor, speziell als Glasbruchmelder.

Die Erfindung wird durch das Beispiel näher erläutert.

### Beispiel

Mit bekannten Methoden wird eine kreisförmige Scheibe (Durchmesser 20 mm und 1 mm Dicke) aus piezoelektrischer Keramik hergestellt. Der in Dickenrichtung der Scheibe zentral verlaufende Kanal wird beim Pressen der Scheibe erhalten. (Er kann auch durch Bohren der ungesinterten Scheibe oder durch Bohren der gesinterten Scheibe erzeugt werden.)

Nach dem Sintern wird die Scheibe durch Aufbringen einer Siebdrucksilberpaste metallisiert. Die zum Siebdruck der Vorderseite verwendeten Siebe sind entsprechend der in Figur 5 dargestellten Form der Metallisierung ausgebildet, wobei beim Siebdrucken die Paste in den Kanal (9) hineingedrückt wird und die Mantelfläche (5′) des Kanals (9) je nach Menge der eingebrachten Paste ganz oder teilweise metallisiert ist.

Die Gegenseite wird mit einem kreisförmigen Sieb vollflächig metallisiert, wobei ebenfalls teilweise die Siebdruckpaste in das Innere des Kanals (9) hineinläuft. Dadurch wird sichergestellt, daß die Metallisierungsflächen (10) und (3) leitend verbunden sind.

Die auf diese Weise aufgebrachten Metallisierungsbeläge werden nun nach einem üblichen Verfahren in einem Durchlaufofen bei 700°C eingebrannt. Nach diesem Arbeitsschritt wird die Scheibe zur Erlangung der piezoelektrischen Aktivität in einem elektrischen Gleichfeld mit ca. 4kV/mm in einem Ölbad polarisiert.

## Patentansprüche

1. Piezoelektrische keramische Wandlerscheibe (1), bei der auf der Vorderseite zwei einander nicht berührende dünne metallische Elektrodenflächen (2) (3) angeordnet sind, von denen die eine (3) mit der metallisierten Rückseite (10) der Scheibe in elektrisch leitender Verbindung steht, dadurch gekennzeichnet, daß die elektrische Verbindung der beiden Seiten durch eine in Dickenrichtung der Scheibe verlaufende Ausnehmung (9) mit metallisierter Mantelfläche (5′) gebildet wird.

2. Wandlerscheibe nach Anspruch 1, dadurch gekennzeichnet, daß die elektrische Verbindung durch eine in Dickenrichtung der Scheibe verlaufende rinnenförmige metallisierte Ausnehmung (9) am Umfang der Scheibe gebildet wird.

3. Wandlerscheibe nach Anspruch 2, dadurch gekennzeichnet, daß mindestens 90 % des Umfangs kreisförmig sind.

4. Wandlerscheibe nach Anspruch 1, dadurch gekennzeichnet, daß die elektrisch leitende Verbindung der beiden Seiten durch ein Loch (9) gebildet wird.

5. Wandlerscheibe nach Anspruch 4, dadurch gekennzeichnet, daß die Flächenform der Scheibe Symmetrieelemente enthält und das Loch (9) im Zentrum der Scheibe angeordnet ist.

6. Wandlerscheibe nach Anspruch 5, dadurch gekennzeichnet, daß die Scheibe (1) kreisförmig ist.

7. Scheibe nach einem der Ansprüche 4 bis 6, dadurch gekennzeichnet, daß die mit der Rückseite in Verbindung stehende Elektrodenfläche (3) der Vorderseite kreisförmig ist und konzentrisch um das Loch (9) angeordnet ist.

8. Scheibe nach mindestens einem der Ansprüche 4 - 7, dadurch gekennzeichnet, daß die nicht mit der Rückseite in Verbindung stehende Elektrodenfläche (2) kreisringförmig ausgebildet und konzentrisch zum Loch (9) angeordnet ist.

9. Verfahren zur Herstellung einer piezoelektrischen Wandlerscheibe, die aus einer Keramikscheibe mit flächig aufgebrachten Metallelektroden besteht, wobei man durch Metallisierung der Keramikscheibe auf deren Vorderseite zwei Elektroden (2) (3) und auf deren Rückseite eine Elektrode (10) aufbringt und man eine Elektrode (3) der Vorderseite mit der Elektrode (10) der Rückseite **elektrisch** verbindet, dadurch gekennzeichnet, daß man eine Scheibe mit einer Ausnehmung (9) verwendet und man zur Bildung der elektrischen Verbindung der beiden Seiten die Manteloberfläche (5) (5′) der Ausnehmung ebenfalls metallisiert.

10. Verfahren gemäß Anspruch 9, dadurch gekennzeichnet, daß man eine Keramikscheibe mit einem Loch verwendet und man die Manteloberfläche (5′) des Lochs ebenfalls metallisiert.

11. Verfahren nach Anspruch 10, dadurch gekennzeichnet, daß man zur Herstellung des Lochs die Scheibe unter Bildung eines Bohrkanals durchbohrt.

12. Verfahren nach Anspruch 9, dadurch gekennzeichnet, daß man die Scheibe und die Ausnehmung gleichzeitig metallisiert.

13. Verfahren nach einem der Ansprüche 9 bis 12, dadurch gekennzeichnet, daß man die zwischen beiden Elektroden der Scheibenvorderseite liegende Fläche (8) mit einem Lack abdeckt und man die Metallisierung in einem Tauchbad stromlos vornimmt.

14. Verfahren nach einem der Ansprüche 9 bis 13, dadurch gekennzeichnet, daß man eine Scheibe einsetzt, die kreisförmig ist.

15. Verfahren nach Anspruch 14, dadurch gekennzeichnet, daß das Loch zentrisch angeordnet wird.

16. Verwendung der piezoelektrischen Wandlerscheibe gemäß Anspruch 1 als Körperschallsensor.

17. Verwendung gemäß Anspruch 16 als Glasbruchsensor.

18. Verwendung der Wandlerscheibe gemäß Anspruch 1 in Surface-Mounted Technology.

## Claims

1. A piezoelectric ceramic transducer disk (1) in which two thin metallic electrode areas (2) (3) which do not touch each other and one (3) of which is in electrically conducting connection with the metallized rear side (10) of the disk are disposed on the front side, wherein the electrical connection of the two sides is formed by a recess (9) extending in the thickness direction of the disk and having a metallized lateral surface (5′).

2. The transducer disk as claimed in claim 1, wherein the electrical connection is formed by a channel-like metallized recess (9) on the circumference of the disk extending in the thickness direction of the disk.

3. The transducer disk as claimed in claim 2, wherein at least 90% of the circumference is circular.

4. The transducer disk as claimed in claim 1, wherein the electrically conducting connection of the two sides is formed by a hole (9).

5. The transducer disk as claimed in claim 4, wherein the surface shape of the disk contains symmetry elements and the hole (9) is disposed in the center of the disk.

6. The transducer disk as claimed in claim 5, wherein the disk (1) is circular.

7. The disk as claimed in any of claims 4 to 6, wherein the electrode area (3) of the front side which is connected to the rear side is circular and is concentrically disposed around the hole (9).

8. The disk as claimed in at least one of claims 4 - 7, wherein the electrode area (2) which is not connected to the rear side is of circular design and is disposed concentrically with respect to the hole (9).

9. A process for producing a piezoelectric transducer disk which is composed of a ceramic disk with two-dimensionally applied metal electrodes, in which, by metallizing the ceramic disk, two electrodes (2) (3) are applied to its front side and one electrode (10) is applied to its rear side and one electrode (3) of the front side is electrically connected to the electrode (10) of the rear side, which process comprises using a disk having a recess (9) and likewise metallizing the lateral surface (5) (5′) of the recess to form the electrical connection between the two sides.

10. The process as claimed in claim 9, wherein a ceramic disk having a hole is used and the lateral surface (5′) of the hole is likewise metallized.

11. The process as claimed in claim 10, wherein the disk is drilled to form a drilled channel to produce the hole.

12. The process as claimed in claim 9, wherein the disk and the recess are metallized simultaneously.

13. The process as claimed in one of claims 9 to 12, wherein the area (8) situated between the two electrodes of the front side of the disk is masked with a resist and the metallization is carried out electrolessly in an immersion bath.

14. The process as claimed in one of claims 9 to 13, wherein a disk is used which is circular.

15. The process as claimed in claim 14, wherein the hole is centrically arranged.

16. The use of the piezoelectric transducer disk as claimed in claim 1 as a structure-borne sound sensor.

17. The use as claimed in claim 16 as a glass-breakage sensor.

18. The use of the transducer disk as claimed in claim 1 in surface mounted technology.

## Revendications

1. Transducteur (1) piézo-électrique céramique en forme de disque dans lequel sont disposés sur la face avant deux minces surfaces d'électrodes (2), (3) métalliques ne se touchant pas, dont l'une (3) est en liaison conductrice électrique avec la face arrière (10) métallisée du disque, caractérisé en ce que la liaison électrique des deux faces est formée par un creux (9) ayant une enveloppe métallisée (5′), s'étendant dans la direction de l'épaisseur du disque.

2. Transducteur en forme de disque selon la revendication 1, caractérisé en ce que la liaison électrique est formée à la périphérie du disque par un creux (9) métallisé, en forme de conduit, s'étendant dans la direction de l'épaisseur du disque.

3. Transducteur en forme de disque selon la revendication 2, caractérisé en ce qu'au moins 90% du périmètre sont circulaires.

4. Transducteur en forme de disque selon la revendication 1, caractérisé en ce que la liaison conductrice électrique des deux faces est formée par un trou (9).

5. Transducteur en forme de disque selon la revendication 4, caractérisé en ce que le disque planiforme contient des éléments de symétrie et que le trou (9) est placé au centre du disque.

6. Transducteur en forme de disque selon la revendication 5, caractérisé en ce que le disque (1) est circulaire.

7. Disque selon l'une des revendications 4 à 6, caractérisé en ce que la surface d'électrode (3) de la face avant, qui est en liaison avec la face arrière, est circulaire et est placée de façon concentrique par rapport au trou (9).

8. Disque selon au moins l'une des revendications 4 - 7, caractérisé en ce que la surface d'électrode (2) qui n'est pas en liaison avec la face arrière est formée en anneau de cercle et est placée de façon concentrique par rapport au trou (9).

9. Procédé pour la fabrication d'un transducteur piézo-électrique en forme de disque qui se compose d'un disque céramique ayant des électrodes métalliques proposées plates, avec lequel on produit, grâce à une métallisation du disque céramique, deux électrodes (2) (3) sur sa face avant et une électrode (10) sur sa face arrière et avec lequel on relie électriquement une électrode (3) de la face avant à une électrode (10) de la face arrière, caractérisé en ce que l'on utilise un disque ayant un creux (9) et que l'on métallise également la surface d'enveloppe (5) (5′) du creux afin de former la liaison électrique des deux faces.

10. Procédé selon la revendication 9, caractérisé en ce que l'on utilise un disque céramique ayant un trou et que l'on métallise également la surface d'enveloppe (5′) du trou.

11. Procédé selon la revendication 10, caractérisé en ce que, pour la fabrication du trou, l'on perce le disque pour former un canal de percement.

12. Procédé selon la revendication 9, caractérisé en ce que l'on métallise simultanément le disque et le creux.

13. Procédé selon l'une des revendications 9 à 12, caractérisé en ce que l'on recouvre la surface (8) se trouvant entre les deux électrodes de la face avant du disque avec un vernis et que l'on effectue la métallisation dans un bain de trempage sans courant.

14. Procédé selon l'une des revendications 9 à 13, caractérisé en ce que l'on utilise un disque qui est circulaire.

15. Procédé selon la revendication 14, caractérisé en ce que le trou est placé de façon à être centré.

16. Utilisation du transducteur piézo-électrique en forme de disque selon la revendication 1 comme capteur sismique.

17. Utilisation selon la revendication 16 comme capteur de bris de verre.

18. Utilisation du transducteur en forme de disque selon la revendication 1 dans la Surface Mounted Technology.
